# EUROPEAN PATENT APPLICATION

(11) **EP 2 610 936 A1**
(43) Date of publication of application: **03.07.2013**
(21) Application number: 11010250.6
(22) Date of filing: 28.12.2011
(51) Int. Cl.: H01L 51/00, C09K 11/06

(54) **Crosslinkable compositions comprising addition polymerizable monomers**

(71) Applicant: SOLVAY SA, 1120 Bruxelles (BE)
(72) Inventor: The designation of the inventor has not yet been filed
(74) Representative: Langfinger, Klaus Dieter

(57) **Abstract**

Crosslinkable compositions for organic light emitting diodes comprising
a) at least one monofunctional compound having one group capable of undergoing addition polymerisation and
b) at least one multifunctional compound having at least two groups capable of undergoing addition polymerisation,
wherein at least one of compounds a) or b) comprises at least one arylamine subunit, and/or at least one subunit derived from 5- or 6-membered aromatic or non-aromatic heterocycles comprising at least one nitrogen atom.

## Description

The present invention is related to new crosslinkable compositions comprising at least two addition polymerizable monomers.

Organic electronic devices typically comprise one or more semiconductive layers between electrodes.

For a number of reasons multilayer devices have been found to be advantageous especially in the field of Organic Light Emitting Diodes (OLED) as this allows to optimize the performance and efficiency of the device.

One challenge in the synthesis of multilayer devices is to avoid the interfacial mixing between different layers which is detrimental for lifetime and efficiency of the device. This is especially important when applying the economically most preferred solution process or the vapour deposition process, where different layers are sequentially applied onto the substrate. As the layer materials are often soluble in organic solvents, application of a subsequent layer out of solution leads to changes in the structure and the morphology of the previous layer which is undesirable.

One approach to overcome this issue is to modify a layer after it has been applied in a manner that the deposition of subsequent layers will not affect its integrity or composition.

One possibility is the use of so called orthogonal solvent systems for the application of sequential layers. Orthogonal solvent system means that for applying a subsequent layer a solvent system is used in which the previously applied layer is insoluble (i.e. has a very low solubility). This limits, however, the materials which can be used and optimum design of the device might be severely limited.

Crosslinking of a layer after it has been applied is another possibility to overcome the problem. After crosslinking the layer normally is no longer soluble and the structure and composition is no longer affected by the application of subsequent layers,

EP A 1 892 730 describes copolymers obtained from mixtures of monomers at least one of which contains a crosslinkable group, i.e. a group that can lead to crosslinking via thermal treatment or exposure to UV or visible radiation. The monomers are capable of undergoing condensation polymerization through the presence of leaving groups which are eliminated in the polymerization reaction. To achieve the desired crosslinking a part or all of the monomers contain, in addition to the leaving groups, a croslinkable group as defined above. During polymerization the leaving groups split off form by-products which have to be removed as they may detrimentally interfere with the performance of the devices. This is particularly true for the preferred leaving groups mentioned in this document amongst which are e.g. halides. Even very small concentrations of halides may be fatal for the efficiency and the lifetime of organic electronic devices and thus they have to be removed quantitatively. This is difficult, time consuming and thus economically unfavourable,

WO 2007/133633 discloses compounds comprising a triaryl amine moiety and at least two crosslinkable groups. Mixtures of the claimed monomers may be used in the manufacture of organic electronic devices. Monofunctional monomers are not contemplated.

US 2011/017988 discloses electroluminiscent elements comprising plural organic compounds layers wherein at least one hole transport layer contains two or more polymerizable compounds, each of which has at least two polymerizable (cross-linkable) groups.

Cross-linkable groups derived from styrene have been found advantageous in the cross-linking desired as the polymerisation can be initiated thermally without the need of any initiator, catalyst or UV radiation.

The products described in the prior art are not fully satisfactory in terms of controlling the crosslinking density and the properties of the crosslinked layers. The cross-linkable groups are mostly an integral part of the electronically active substance and crosslinking thereof might have an influence on the electronic properties and thus on performance and lifetime of the devices.

There still exists a need for cross-linkable products which can be used in multi-layer electroluminescent devices and the properties of which can be tailored to the specific situation. The degree of crosslinking is one parameter which would be desirable to control.

Accordingly it was an object of the invention to provide compositions with which layers in electroluminescent devices can be formed and the properties of which can be individually adapted to the specific needs.

This object has been achieved with the compositions in accordance with claims 1.

Preferred embodiments of the present invention are set forth in the dependent claims and in the detailed description hereinafter.

The crosslinkable compositions in accordance with the present invention comprise at least two different monomers which are distinguished by the number of addition-polymerizable groups. According to a preferred embodiment of the present invention, at least one, even more preferably all of the monomers are free of leaving groups which could undergo a condensation polymerization so that there are no low molecular weight by-products formed in the course of the polymerization and crosslinking. Addition-polymerizable, when used in the context of the present invention means a functionality in the molecule which can undergo polymerization through an addition reaction where many monomers are bound together via rearrangement of bonds without the loss of any atom or molecule. Whereas monomers suitable for condensation polymerization have to have at least two leaving groups to propagate the polymerization (monofunctional monomers terminate the chain propagation), addition-polymerizable monomers need only one functionality to propagate the chain growth. Addition-polymerizable monomers with two addition-polymerizable functionalities lead to crosslinking, whereas in condensation-polymerizable monomers at least three functional groups (two leaving groups and one additional functionality) are necessary to achieve a crosslinking.

In the crosslinkable compositions in accordance with the present invention, component a), a compound with at least one addition-polymerizable group suffices for forming a polymer chain, whereas component b) having at least two addition-polymerizable groups provides the functionality for the crosslinking of the composition when subjected to the conditions of addition polymerization.

Groups capable of undergoing addition polymerization generally comprise a double bond at which the addition polymerization reaction is initiated. This initiation can be effected thermally or through other means of energy transfer to the double bond, e.g. UV or visible radiation or through radical initiators.

Whereas in principle any double bond can be subjected to addition polymerization (ethylene is the most simple example of an addition-polymerizable monomer), in accordance with a preferred embodiment of the present invention, the addition polymerizable-group(s) in at least one of compounds a) or b), and even more preferably in both compounds a) and b) is respectively are selected from the group consisting of vinyl groups and benzocyclobutene groups.

Vinyl group containing monomers have the common structural element -C(R)=CR'R" wherein R, R' and R", independently from one another may preferably be hydrogen, halogen or a C₁-C₈ alkyl group, in which alkyl group the hydrogen atoms may be partly or fully replaced by other atoms, preferably by halogen atoms.

Preferred addition polymerizable vinyl groups are those derivable from the vinyl group itself, from vinyl aromatic monomers like e.g.styrene, from (meth)acrylic acid or from vinyl ethers, in particular halogenated vinyl ethers (e.g. trifluorovinylethers).

Benzocyclobutene groups are also susceptible to addition polymerization and constitute another preferred embodiment in accordance with the present invention.

Besides the addition polymerizable group, at least one of the compounds a) or b) comprises at least one arylamine subunit and/or at least one subunit derived from a 5- or 6-membered aromatic or non-aromatic heterocycle comprising at least one nitrogen atom.

While the structure of the arylamine subunit is not subject to specific limitations and can be broadly selected by the skilled person applying his knowledge concerning reactivity and polymerization behaviour of the respective compounds, the following subunits are provided by way of example and are generally preferred in accordance with the present invention.

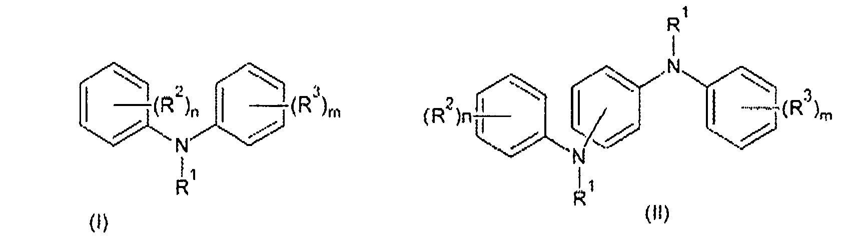

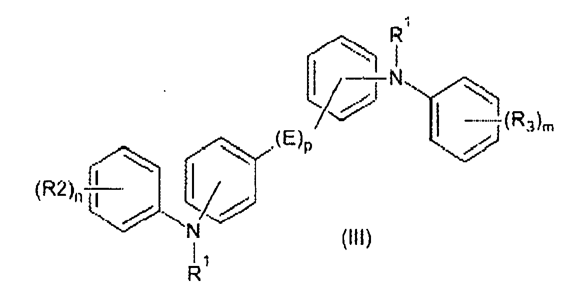

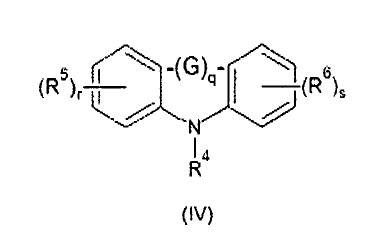

wherein
R¹ and R⁴, independently from one another are selected from H, C₁-C₈ alkyl, C₁-C₈ haloalkyl, C₅-C₃₀ aryl, C₅-C₃₀ -haloaryl, C₁-C₈ alkoxy or C₅-C₃₀-aryloxy or an addition polymerizable group,
R² to R⁶, which may be the same or different at each occurrence, are selected from H, C₁-C₈ alkyl, C₁-C₈ haloalkyl, C₅-C₃₀ aryl, C₅-C₃₀ -haloaryl, C₁-C₈ alkoxy or C₅-C₃₀ -aryloxy or NR⁷R⁸ wherein R⁷ and R⁸ are selected from the group consisting of H, C₁-C₈ alkyl, C₁-C₈ haloalkyl, C₅-C₃₀ aryl, C₅-C₃₀ -haloaryl, C₁-C₈ alkoxy or C₅-C₃₀ -aryloxy or an addition-polymerizable group, or R² to R⁶ may form an annealed ring system together with the ring they are attached to.
E is selected from the group consisting of -CH=CH-, -C(R⁹)=C(R¹⁰), O, S or NR¹¹R¹², wherein R⁹ to R¹², which may be the same or different at each occurrence, may have the meanings as defined above for R²;
G is a group -CH₂-, -CH₂-CH₂- or -CH=CH-,
n, m, r and s, independent from one another, are an integer of from 0 to 5, and
p and q, independently from one another are 0 or 1.

Subunits derived from 5- or 6-membered heterocycles comprising at least one nitrogen atom are preferably derivatives of five or six membered heteroaryl groups comprising at least one nitrogen atom.

Preferred 5- or six membered heteroaryl groups comprising at least one nitrogen atom are preferably selected from

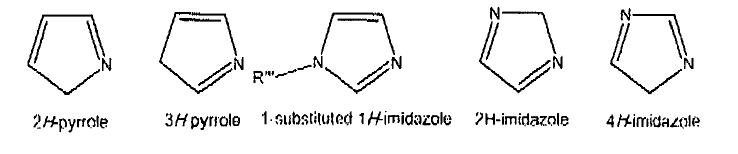

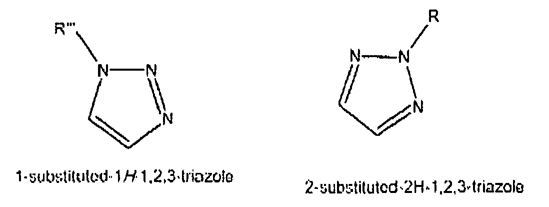

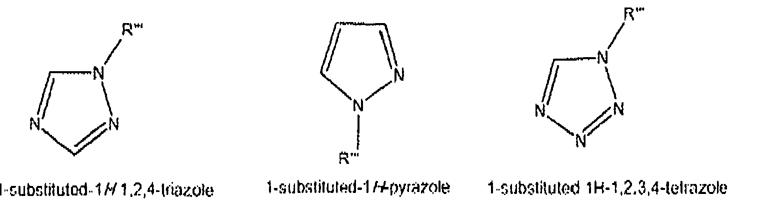

wherein R"' represents a substituent or selected from

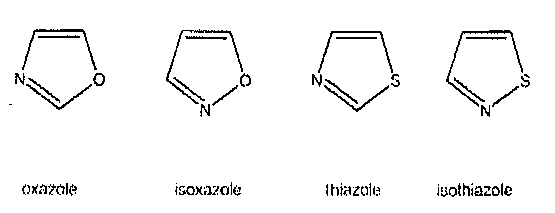

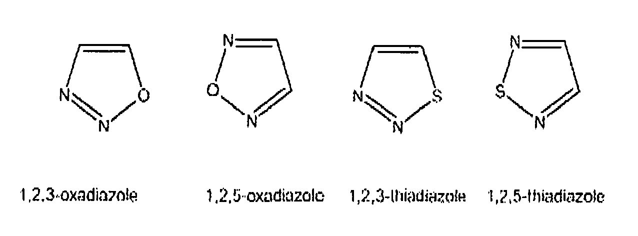

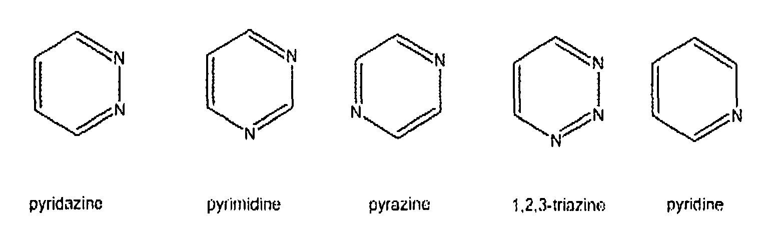

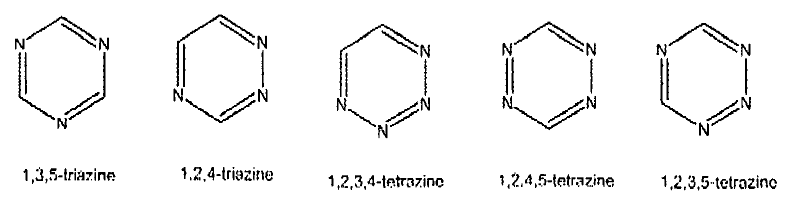

As is apparent from the foregoing detailed description the compounds a) and b) in the compositions of the present invention comprise one respectively at least two addition polymerizable groups and at least one of compounds a) and b) also comprises an arylamine subunit, preferably a subunit of formulae I to IV above, and/or at least one subunit derived from a 5- or 6-membered aromatic or non-aromatic heterocycle comprising at least one nitrogen atom.

The addition-polymerizable group may be a part of any of the substituents R¹ to R¹² in the compounds of formulae I to IV or it may be present in addition to the substituents defined in connection with formulae I to IV.

In compounds with a subunit derived from a 5- or 6-membered aromatic or non-aromatic heterocycle comprising at least one nitrogen atom, the addition-polymerizable group may be a substituent directly attached to said 5- or 6 membered heterocycle or may be part of a substituent attached to said heterocycle.

According to a further preferred embodiment of the present invention, both compounds a) and b) comprise an arylamine subunit, preferably of formulae I to IV above.

It is not mandatory that both compounds a) and b) comprise an arylamine subunit and thus one of compounds a) and b) may be derived from other compounds comprising addition polymerizable groups. In particular compound b) comprising at least two addition polymerizable groups may be derived from common crosslinking monomers known to the skilled person as for e.g. the compounds of formulae V to VII, to name only three examples

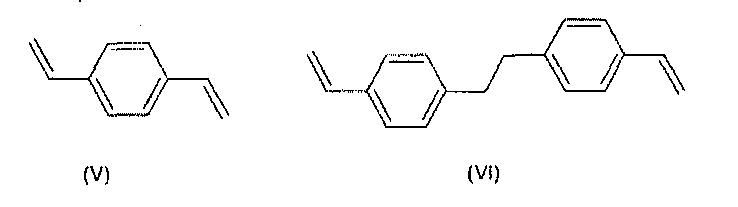

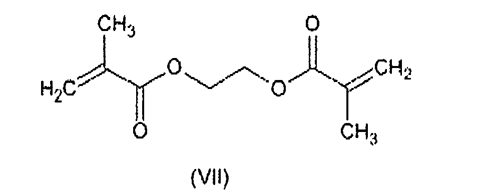

Particularly preferred compounds a) comprising one addition-polymerizable group are the compounds of formulae VIII to XVI

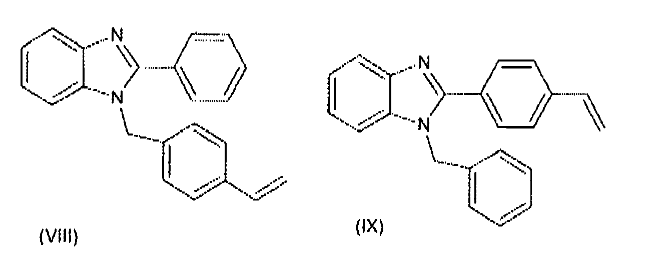

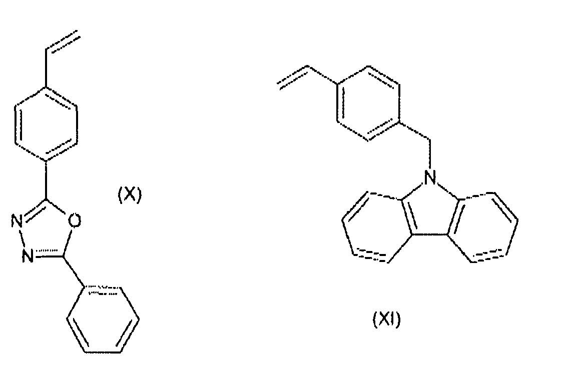

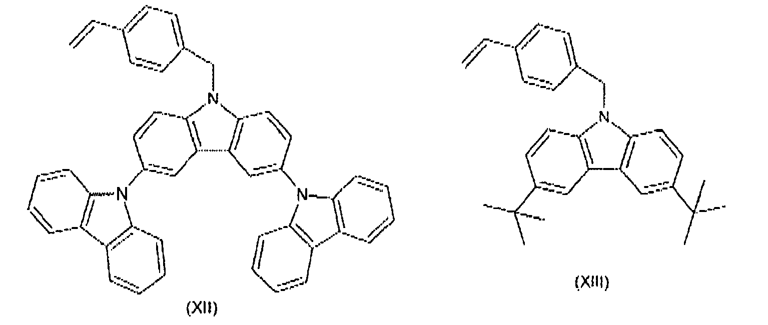

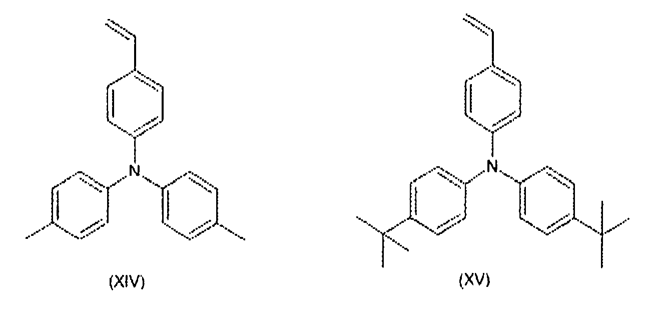

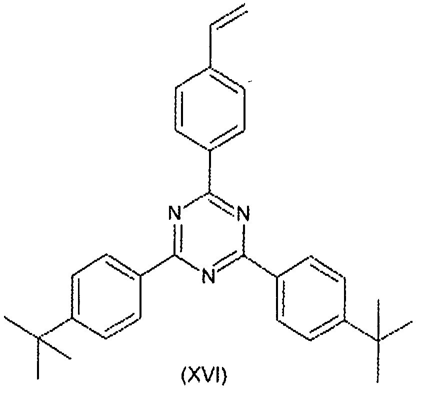

Preferred Compounds b) with at least two addition-polymerizable groups and arylamine subunit, and/or at least one subunit derived from a 5- or 6-membered aromatic or non-aromatic heterocycle comprising at least one nitrogen atom are selected from the compounds of formulae XVII to XXIII

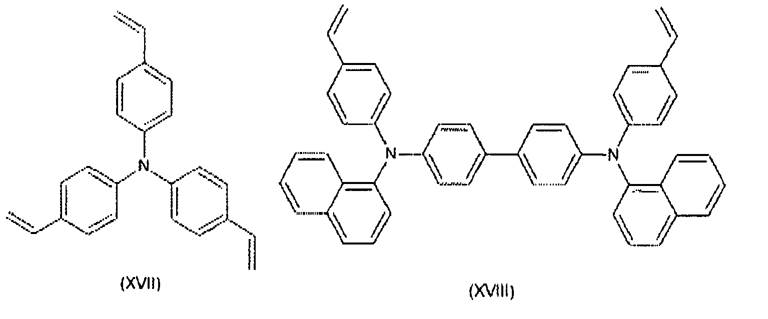

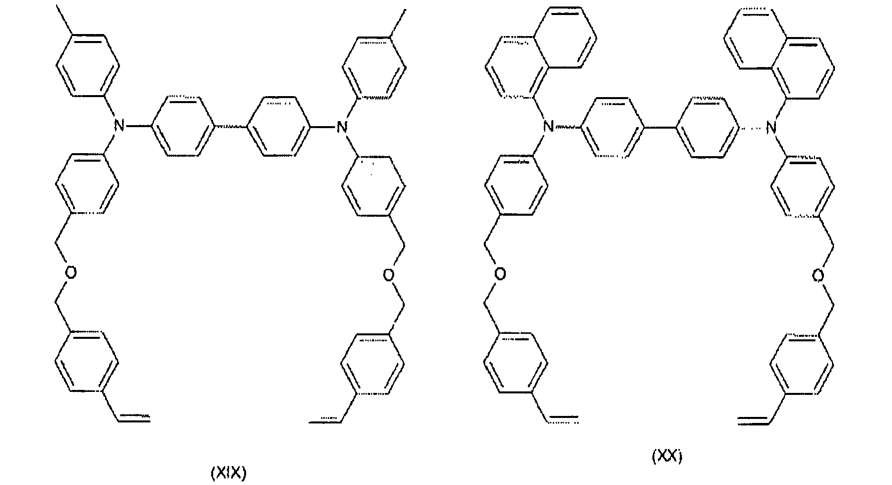

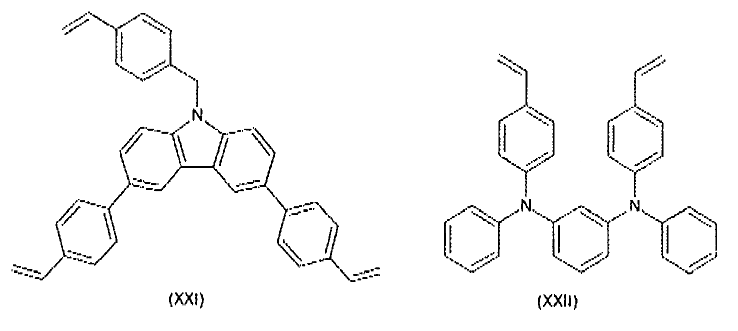

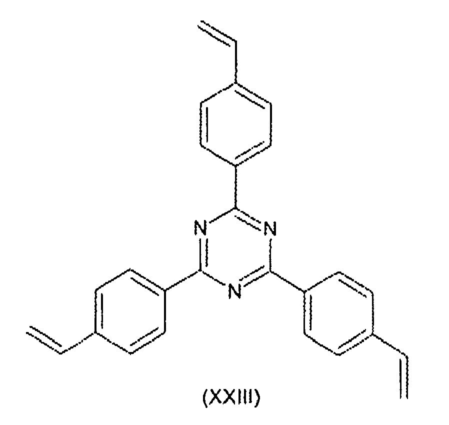

In the abovementioned exemplary compounds of formulae V to XXII the aromatic rings in the molecules can carry one or more substitutents.

The crosslinkable compositions in accordance with the present invention comprise at least one compound a) having one addition polymerizable group and at least one compound b) having at least two addition polymerizable groups. Monofunctional compound a) is effective in the main chain propagation whereas the at least bifunctional compound b) is effective in achieving a certain degree of crosslinking which is desirable in the formation of multilayered organic electronic devices by a solution process or by a gas phase process as the crosslinking prevents reaction of the different layers with each other which might have disadvantageous effects.

By adjusting the weight ratio of compounds a) and b) in the compositions in accordance with the present invention it is possible to adjust the crosslinking density or the efficiency of crosslinking.

The efficiency of crosslinking can be most easily be determined through a washing test with toluene which is carried out after polymerization. The thickness of the layer is determined before and after washing with toluene at room temperature by spin coating of pure toluene. The higher the remaining thickness after washing, the higher is the efficiency of crosslinking and the better is the stability of the deposed layer against modifications in the course of deposing the subsequent layer.

Depending on the relative reactivity of the monofunctional compound a) and the multifunctional compound b) molar ratios of compound a) and b) are usually chosen in the range of from 20:1 to 1:20, preferably in the range of from 10:1 to 1:10. The skilled person will select the appropriate ratio accordingly.

In addition to the molar ration of compounds a) and b) the degree of crosslinking can also be influenced by the reaction temperature and the reaction time and the skilled person will select the appropriate reaction conditions accordingly based on the physicochemical parameters of the compounds comprised in the composition in accordance with the present invention.

For practical reasons it is preferably to use compounds b) which are effective in achieving crosslinking at temperatures not detrimentally influencing the polymer formed. Usually reaction temperatures for the desired crosslinking are in the range of from 150 to 250 °C and preferably compound b) is selected to achieve a desired degree of crosslinking at a temperature of not more than 220, in particular of not more than 200°C.

Particularly preferred mixtures of compounds a) and b) are selected from the following combinations:

Compound XIV in combination with compounds V, VI or XVII

Compound VIII in combination with compound XVII

Compound IX in combination with compound XVII

Compound XIII in combination with compounds V, VI and XVII

Compound XV in combination with compound XVII

Compound XVI in combination with compound XXIII

The compounds a) and b) in the compositions in accordance with the present invention can be obtained in accordance with methods described in the literature and known to the skilled person in the respective field of the art.

By way of example only some processes for the synthesis of certain compounds a) and b) are reproduced in some more detail below; the skilled person will adjust the reactants and the reaction conditions for the synthesis of other compounds a and b).

An exemplary synthesis route for compound XVIII is as follows:

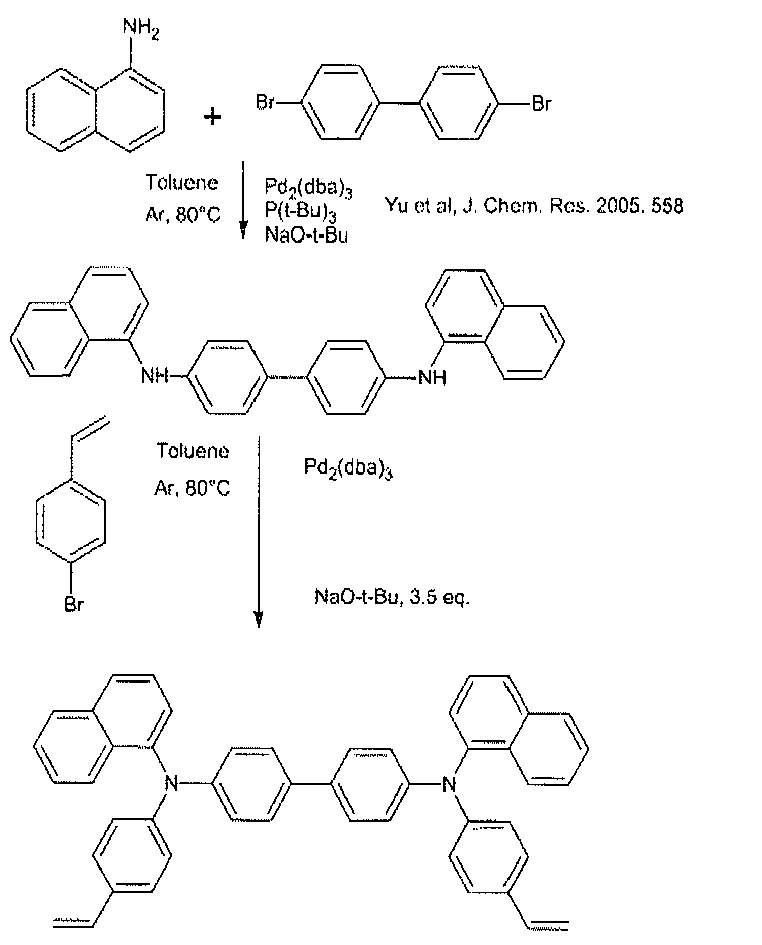

Exemplary synthesis for compound XXIII

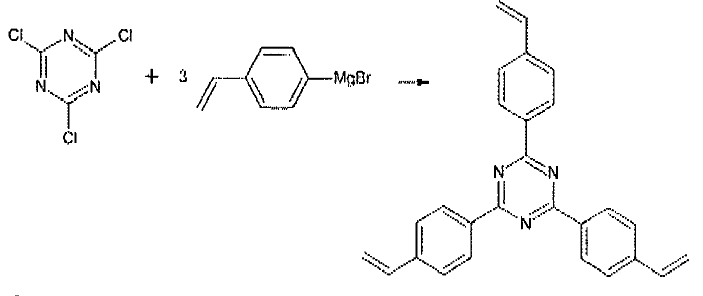

Compound XVI can be obtained in an analogous manner by using the respective starting materials.

Compound XIV may be obtained in accordance with Valsan et al., Tetrahedron 2005, 61, 9775 or in a manner as disclosed in US 7,276,627.

Compounds XIV and XVII may be obtained according to the so called Buchwald-Hartwig reaction by using the suitable starting materials.

The compositions in accordance with the present invention may be used for the formation of any layer of a multi-layered organic electronic device, in particular an OLED stack (hole transporting layer, electron transport layer, hole blocking layer etc.). The person skilled in the art will select the suitable compounds a) and b) in accordance with the desired function of the layer.

With the compositions in accordance with the present invention, the crosslinking density of a film layer obtained from the compositions can be finely controlled and several advantages may be obtained, e.g. lowering of the glass transition temperature which allows a better removal of solvent, a higher double bond conversion and a lower energy required for curing. Furthermore, shrinkage and film morphology are improved.

The compounds a) and or b) having arylamine subunits are particularly suitable for the manufacture of hole transport layers in OLEDs and thus another embodiment of the present invention relates to the use of the compositions in accordance with the present invention for the manufacture of hole transport layers in OLEDs.

Finally a third embodiment of the present invention relates to polymers obtained from the compositions in accordance with the present invention.

The compositions in accordance with the present invention are particularly useful in the manufacture of multilayered OLED devices by solution processes or by vapour phase processes where the previously deposed layer has to be inert under the reaction conditions with the subsequent deposited layer to avoid undesired changes in the properties of the device. Solution and vapour phase processes for the manufacture of such multilayered organic electronic devices are known to the skilled person and described in the literature so that no detailed description is necessary here.

An OLED generally comprises :
a substrate, for example (but not limited to) glass, plastic, metal;
an anode, generally transparent anode, such as an indium-tin oxide (ITO)
anode;
a hole injection layer (HIL) for example (but not limited to) PEDOT/PSS;
a hole transporting layer (HTL);
an emissive layer (EML);
an electron transporting layer (ETL);
an electron injection layer (EIL) such as LiF, Cs₂CO₃
a cathode, generally a metallic cathode, such as an Al layer.

## Claims

1. Crosslinkable compositions comprising
a) at least one monofunctional compound having one group capable of undergoing addition polymerisation and
b) at least one multifunctional compound having at least two groups capable of undergoing addition polymerisation,
wherein at least one of compounds a) or b) comprises at least one arylamine subunit, and/or at least one subunit derived from 5- or 6-membered aromatic or non-aromatic heterocycles comprising at least one nitrogen atom.

2. Crosslinkable compositions in accordance with claim 1 wherein the group capable of undergoing addition polymerisation is selected from vinyl groups or benzocyclobutene groups.

3. Crosslinkable compositions in accordance with claim 2 wherein the vinyl group is selected from vinyl, vinylphenyl, vinylbenzyl or vinyl ethers..

4. Crosslinkable compositions in accordance with any of claims 1 to 3 wherein the monofunctional compound is selected from the group consisting of vinyl aromatic derivatives, acrylic acid derivatives and methacrylic acid derivatives.

5. Crosslinkable compositions in accordance with any of claims 1 to 3 wherein at least one of compounds a) or b) comprises an arylamine subunit.

6. Crosslinkable compositions in accordance with claim 5 wherein compound a) and compound b) are selected from the compounds of formulae VIII to XXIII

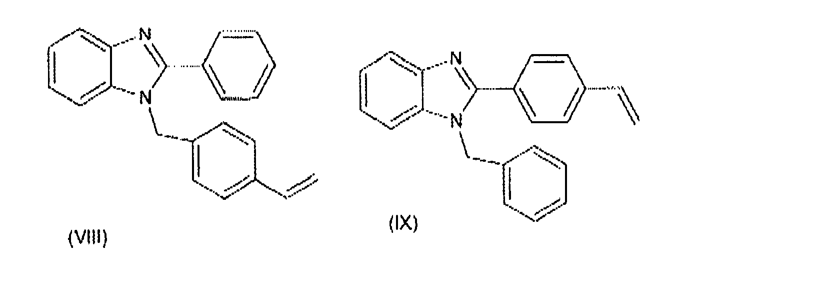

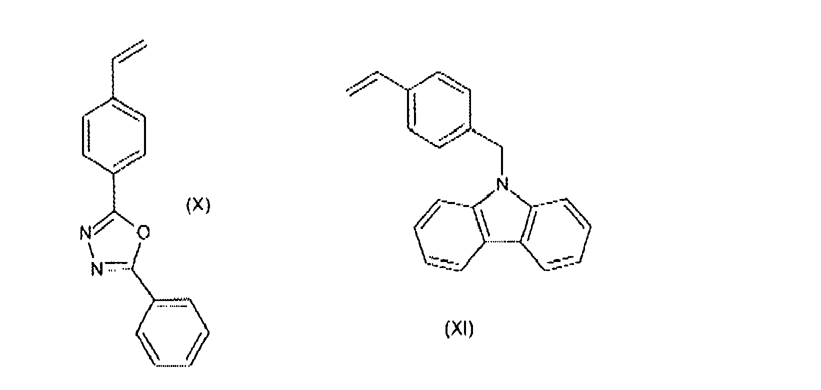

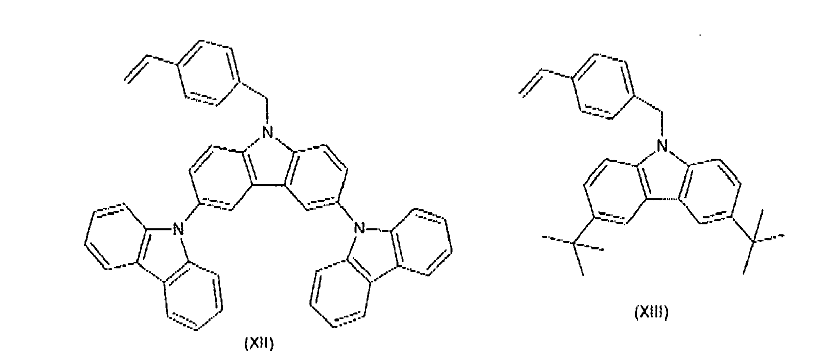

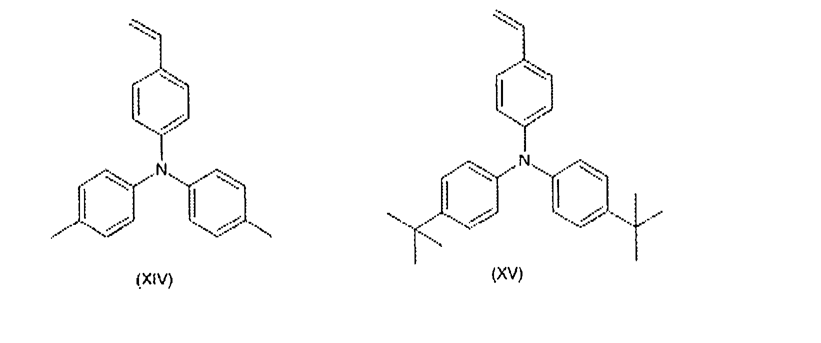

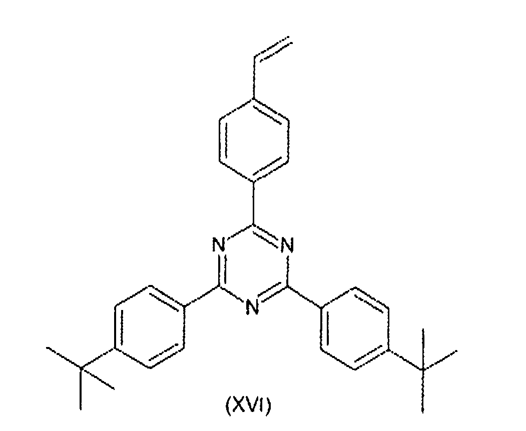

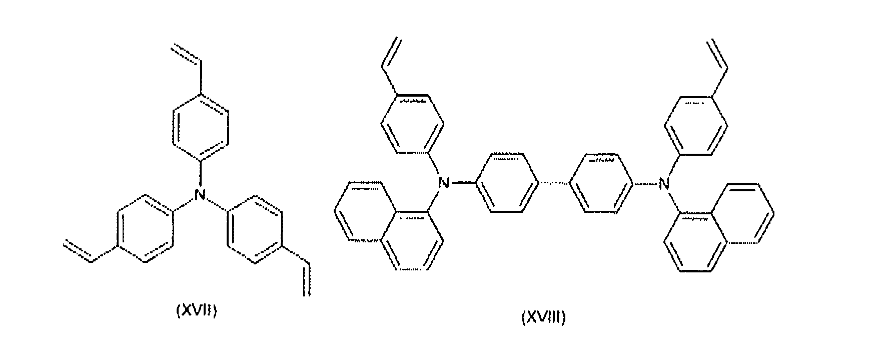

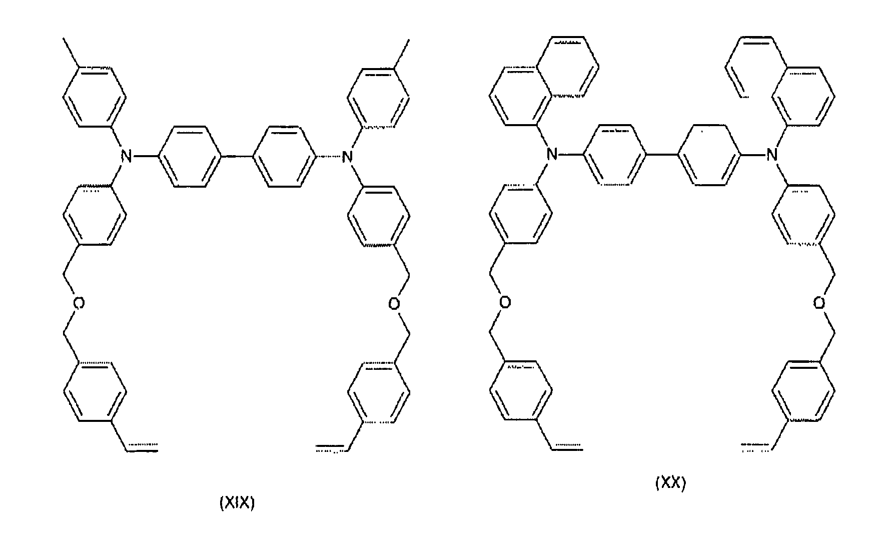

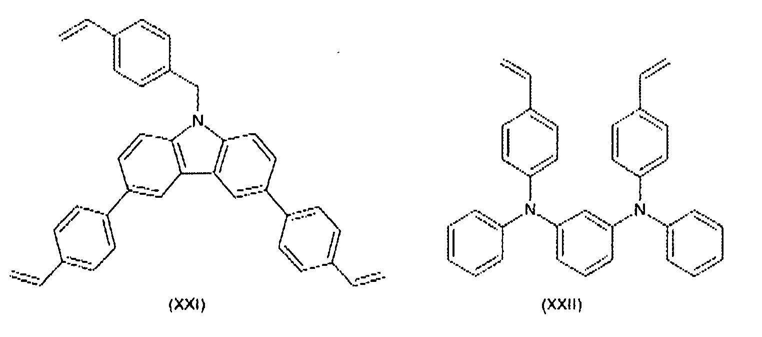

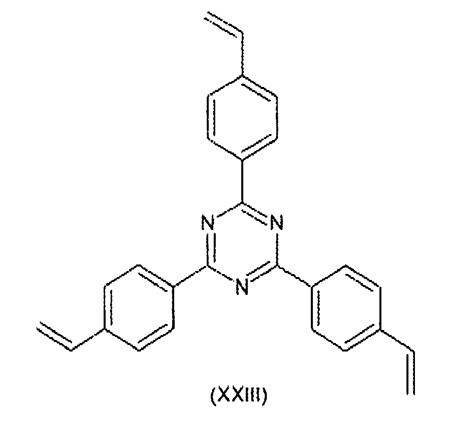

7. Polymers obtained from compositions in accordance with claims 1 to 6.

8. Use of compositions as claimed in any of claims 1 to 6 for the manufacture of organic electronic devices.

9. Use in accordance with claim 8 wherein the organic electronic device is an electroluminiscent device.

10. Use in accordance with claim 9 wherein the electroluminescent device is an organic light emitting diode.

11. Organic electronic device comprising a component derived from the polymerisation of a crosslinkable composition as claimed in any of claims 1 to 6.

12. Multilayered electroluminescent device comprising at least one layer derived from the polymerization of a composition as claimed in any of claims 1 to 6.

13. Organic light emitting diode comprising at least one layer derived from the polymerisation of a crosslinkable composition as claimed in any of claims 1 to 6.

14. Use of the compositions in accordance with any of claims 1 to 6 in the manufacture of hole transport layers in organic light emitting diodes.
